# EUROPEAN PATENT SPECIFICATION

(11) **EP 3 771 305 B1**
(45) Date of publication and mention of the grant of the patent: **18.03.2026**
(21) Application number: 20180256.8
(22) Date of filing: 16.06.2020
(51) Int. Cl.: H05K 5/02

(54) **ELECTRONIC DEVICE UNIT**
ELEKTRONISCHE VORRICHTUNGSEINHEIT
UNITÉ DE DISPOSITIF ÉLECTRONIQUE

(30) Priority: 22.07.2019 JP 2019134582
(43) Date of publication of application: 27.01.2021
(73) Proprietor: Tamura Corporation, Tokyo 178-8511 (JP)
(72) Inventor: TAMORI, Isamu, Saitama, 350-0214 (JP)
(74) Representative: Plougmann Vingtoft a/s

(56) References cited:
- US-A1- 2010 079 021
- US-A1- 2011 253 413
- US-A1- 2016 157 390
- US-A1- 2017 223 854

## Description

### Technical Field

The present invention relates to an electronic device unit having a case, and more particularly relates to an electronic device unit in which the pressure in the case is adjusted using a filter.

### Background Art

In the electronic device unit described in the publication (JP2019-008917A1) issued by Japan Patent Office, the internal pressure in a case is adjusted by an internal pressure adjusting filter disposed on an outer surface of the case. However, disposing the internal pressure adjusting filter on the outer surface of the electronic device unit leads to poor appearance as a product and impairs the design attractiveness of the electronic device unit.

US 2010/079021 A1 discloses a liquid tightly sealed housing has an electrical or electronic device arranged in an internal volume of the housing, a channel with a globally vertical main axis, passing through an upper wall of the housing to connect the internal volume of the housing to outside, and closure apparatuses for making the channel liquid-tight and gas-permeable. The closure apparatuses are arranged at least partly on the upper wall of the housing and at an upper end of the channel so as to prevent any liquid accumulation in the channel.

US 2016/157390 A1 discloses a pressure compensation device for securing the air permeability of the electronic control unit (ECU) of a vehicle. A pressure compensation device according to an aspect of the present invention includes a vent unit integrated with a connector on a part of an ECU on which an electronic control element is mounted, wherein a vent hole penetrating the inside and outside of the case of the ECU in which the electronic control element is received is formed in the vent unit and a cover unit integrated with a vehicle-side connector in such a way as to form electrical connection with the ECU and configured to form a protection wall by covering part of the upper side of the vent unit when the ECU-side connector and the vehicle-side connector are coupled.

It is an object of the present invention to prevent the design attractiveness of an electronic device unit from being impaired even if an internal pressure adjusting filter is disposed.

The present invention adopts the following solutions to solve the aforesaid problem. It should be noted that the terms in the following solutions and parentheses are only examples and the present invention is not limited by these. Further, the present invention can be an invention including at least one of the subject matters presented in the following solutions. Further, the subject matters presented in the following solutions each can have a more specific concept by an element limiting the subject matter being added and can also have a more generic concept by an element limiting the subject matter being deleted.

An electronic device unit according to the invention includes the following configurations.
(1) It includes a box-shaped case. The case is a member having a rectangular parallelepiped shape. Inside the case, an electronic component is housed.
(2) An opening is formed in the case in (1). The opening is formed in a side surface of the case.
(3) In the case in (1), a first hole is formed in the vicinity of (near, at a position adjacent to, in the same surface as) the opening in (2).
(4) An internal pressure adjusting filter which adjusts an internal pressure of the case in (1) is disposed at a position where it overlaps the first hole in (3). Note that "overlap" includes not only directly overlap physically but also indirectly overlap in an upper layer or a lower layer.
(5) An electronic component (bushing member) is disposed at a position where it overlaps the opening in (2), the first hole in (3), and the internal pressure adjusting filter in (4).
(6) In the electronic component in (5), a second hole is formed at a position where it overlaps the first hole in (3) and the internal pressure adjusting filter in (4). Note that the first hole and the second hole may be circular holes, may be holes in a shape other than a circular shape, or may be cuts.

According to the invention, since the internal pressure adjusting filter is disposed at the back of (under, on a more inner side than, behind) the second hole of the electronic component, the internal pressure adjusting filter is hidden behind the electronic component and thus can be less conspicuous than in a type in which the internal pressure adjusting filter is disposed on an outer wall of the case, and as a result, it is possible to prevent the design attractiveness of the electronic device unit from being impaired by the internal pressure adjusting filter.

Further, according to the invention, since the second hole is disposed in the electronic component, there is no need to form a conspicuous hole in the outer wall of the case, making it possible to dispose the internal pressure adjusting filter without impairing the outer appearance of the case.

Further, according to the invention, since the electronic component can press the internal pressure adjusting filter, a specialized component for pressing the internal pressure adjusting filter is not necessary, enabling a reduction in the number of components.

Furthermore, according to the invention, since the electronic component can press the internal pressure adjusting filter, it is possible to avoid a situation in which the internal pressure adjusting filter comes off accidentally.

According to the invention, the following features are added.
(1) The electronic component includes: a main body portion disposed at a position where it overlaps the opening, the first hole, and the internal pressure adjusting filter; and a wiring portion extending from the main body portion in a direction toward an outer side of the case.
(2) The second hole is formed in the main body portion in (1) and is formed at a position where it does not overlap the wiring portion in (1).

According to the invention, the second hole is formed in the main body portion at the position where it does not overlap the wiring portion, and accordingly, when a test of sticking a tape on the second hole is conducted before the shipment of the electronic device unit, it is possible to reduce the occurrence of a situation in which the wiring portion becomes an obstacle to make it difficult to stick the tape, enabling improved work efficiency.

According to the invention, the following features are added.
(1) The case has a recess dented toward an inner side of the case.
(2) The main body portion is at least partly housed in the recess in (1).

According to the invention, since the main body portion is at least partly housed in the recess, it is possible to bury at least part of the main body portion, which is part of the electronic component, inside the case, making it possible to reduce deterioration in design attractiveness which would occur if the main body portion protrudes too much to the outside of the case.

According to the invention, the following features are added.
(1) The opening and the first hole are formed in the recess.
(2) The internal pressure adjusting filter is disposed in a stacked manner on the first hole formed in the recess.

According to the invention, since the opening, the first hole, and the internal pressure adjusting filter are all disposed together in the recess, it is possible to dispose these elements compactly, enabling space-saving.

According to a further embodiment, the main body portion is disposed at a position where it overlaps the opening which is formed in the recess, and the first hole and the internal pressure adjusting filter which are disposed in the recess. Note that the internal pressure adjusting filter may be disposed in a portion further dented than the recess.

According to this further embodiment, since the main body portion is disposed at the position where it overlaps the opening which is formed in the recess and the first hole and the internal pressure adjusting filter which are disposed in the recess, only by housing the main body portion in the recess, it is possible to stack the main body portion on the opening, the first hole, and the internal pressure adjusting filter, enabling improved work efficiency.

According to the present invention, it is possible to prevent the design attractiveness of the electronic device unit from being impaired even if the internal pressure adjusting filter is disposed.

### Brief description of the drawings

In the drawings used in the description of embodiments,
FIG. 1 is a view illustrating a charger 100 of one embodiment, and so on,
FIG. 2A and FIG. 2B are perspective views illustrating the charger 100,
FIG. 3 is an exploded perspective view illustrating the charger 100,
FIG. 4A and FIG. 4B are perspective views illustrating an upper case 20,
FIG. 5A and FIG. 5B are perspective views illustrating a lower case 27,
FIG. 6A to FIG. 6D are views illustrating a bushing member 50,
FIG. 7A and FIG. 7B are views illustrating an inlet 80,
FIG. 8A to FIG. 8F are views illustrating a first fixing pin 70,
FIG. 9A to FIG. 9F are views illustrating a second fixing pin 90,
FIG. 10 to FIG. 17 are views illustrating a method of fixing the bushing member 50,
FIG. 18 to FIG. 20 are views illustrating a method of fixing the inlet 80,
FIG. 21A and FIG. 21B are perspective views illustrating a charger 100A of another embodiment,
FIG. 22 is a view illustrating a bushing member 50A of the other embodiment,
FIG. 23 is a vertical sectional view of the charger 100A of the other embodiment, and
FIG. 24 is a vertical sectional view of the charger 100 of the one embodiment.

### Preferred embodiments

Embodiments of the present invention will be hereinafter described with reference to the drawings.

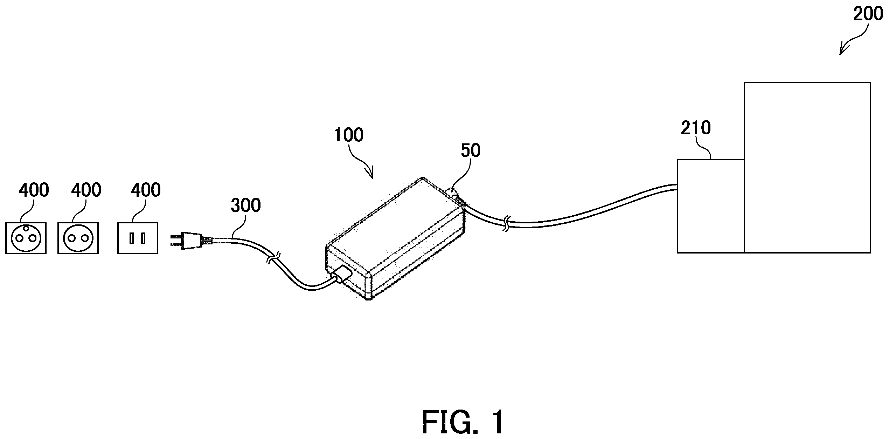

FIG. 1 is a view illustrating a charger 100 of this embodiment, and so on. It should be noted that, in some parts of the drawings, the actual size or length of an object is changed or an existing component is not illustrated.

The charger 100 (electronic device unit) is a device for charging a battery 210 included in an electronic device 200. The battery 210 may be removable or unremovable from the electronic device 200.

The electronic device 200 is a device that can be operated by power supplied from the battery 210. The electronic device 200 may be a device that can be operated not only by the power supplied from the battery 210 but also by power supplied from a commercial power source. Specific details of the electronic device 200 are not limited, and the electronic device 200 is, for example, a portable information terminal, a mobile phone, a laptop personal computer, a video camera, or the like.

A power cord 300 is connectable to the charger 100, and by inserting a compatible plug of the power cord 300 into an outlet 400 of a type for each nation/district that supplies commercial power, it is possible to supply the charger 100 with charging power. The charger 100 is an AC adapter which converts alternating-current power which is input through the power cord 300, into a direct-current power to output the direct-current power. It should be noted that the type of the outlet 400 and the plug is not limited to the illustrated examples.

Further, a bushing member 50 is attached to the charger 100, and it is possible to charge the battery 210 by inserting a wiring portion of the bushing member 50 into the battery 210.

The charger 100 is capable of charging the battery 210 by being connected directly to the battery 210. Further, in a case where there is a specialized device for charging, by removing the battery 210 from the electronic device 200, setting the removed battery 210 on the specialized device, and connecting the charger 100 and the specialized device using the wiring portion of the bushing member 50, the charger 100 is capable of charging the battery 210 indirectly through the specialized device.

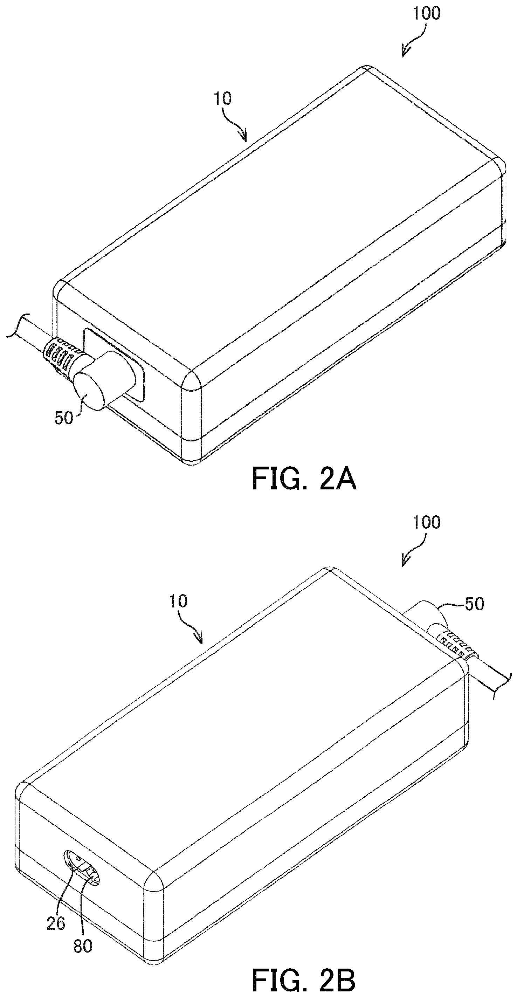

FIG. 2A is a perspective view of the charger 100 seen from a bushing member 50 side, and FIG. 2B is a perspective view of the charger 100 seen from an inlet 80 side.

The charger 100 includes a box-shaped case 10.

The case 10 has a flat rectangular parallelepiped shape, the bushing member 50 is attached to one side surface thereof (one of the side surfaces arranged in the longitudinal direction of the case 10), and an opening 26 for inlet into which the power cord 300 (see FIG. 1) is insertable is formed in a side surface opposite to the side surface to which the bushing member 50 is attached. Inside the opening 26 for inlet, the inlet 80 is disposed.

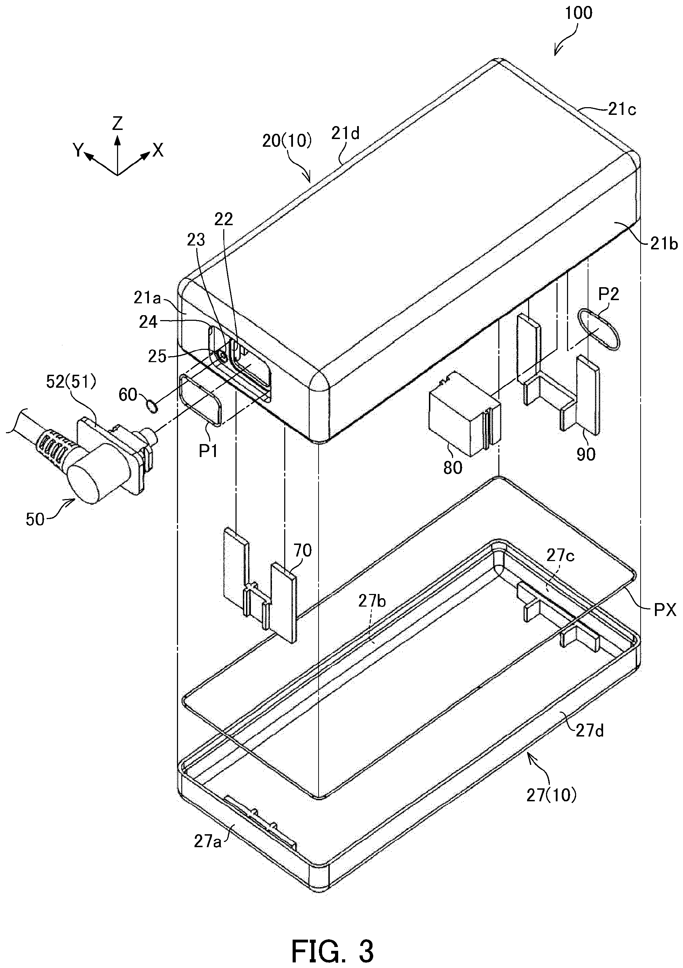

FIG. 3 is an exploded perspective view illustrating the charger 100 of this embodiment.

In FIG. 3, the longitudinal direction (left-right direction) of the charger 100 is an X direction, the short-side direction (front-rear direction) of the charger 100 is a Y direction, and the up-down direction of the charger 100 is a Z direction.

The case 10 includes an upper case 20 (first case) and a lower case 27 (second case).

The upper case 20 and the lower case 27 each include one flat surface (upper surface or bottom surface) and four side surfaces.

The upper case 20 has a semi-box shape with its lower end surface open, and the lower case 27 has a semi-box shape with its upper end surface open. The upper case 20 and the lower case 27 are combined to form the single completed box-shaped case.

The height of the upper case 20 is larger than the height of the lower case 27. This is because the bushing member 50 and the inlet 80 are attached to the upper case 20.

The upper case 20 and the lower case 27 are combined, with an outer peripheral packing PX therebetween.

The upper case 20 and the lower case 27 are formed of resin. Further, the outer peripheral packing PX and other packings are formed of rubber or resin.

The bushing member 50, an internal pressure adjusting filter 60, and a first packing P1 are attached to a first side surface 21a of the upper case 20.

The bushing member 50 is fixed by a first fixing pin 70.

The internal pressure adjusting filter 60 is a circular sheet and is a member which adjusts the internal pressure of the case 10. The internal pressure adjusting filter 60 does not allow the passage of water but allows the passage of gas (air). The diameter of the internal pressure adjusting filter 60 is approximately several millimeters (for example, 4.0 mm). The internal pressure adjusting filter 60 is composed of a filter portion, a ring-shaped double-sided adhesive tape which is disposed on a lower layer of the filter portion, and so on. A reason why the ring-shaped double-sided adhesive tape is stuck is to prevent a gap from being formed between the internal pressure adjusting filter 60 and the upper case 20 (prevent air from leaking from between the internal pressure adjusting filter 60 and the upper case 20).

Around the internal pressure adjusting filter 60, a sheet which protects the internal pressure adjusting filter 60 (for example, an annular sheet disposed such that its center portion is the internal pressure adjusting filter 60) may be disposed.

Further, the inlet 80 and a second packing P2 are attached to a third side surface 21c of the upper case 20.

The inlet 80 is fixed by a second fixing pin 90.

Between the upper case 20 and the lower case 27, electronic components (a substrate, wiring lines, a transformer, a rectifier, and so on), an electronic circuit device (control circuit device), and so on which are necessary for operating the charger 100 are disposed, though not illustrated.

Further, a second side surface 21b and a fourth side surface 21d of the upper case 20 are flat surfaces without any opening formed therein.

Further, a first side surface 27a, a second side surface 27b, a third side surface 27c, and a fourth side surface 27d of the lower case 27 are flat surfaces without any opening formed therein.

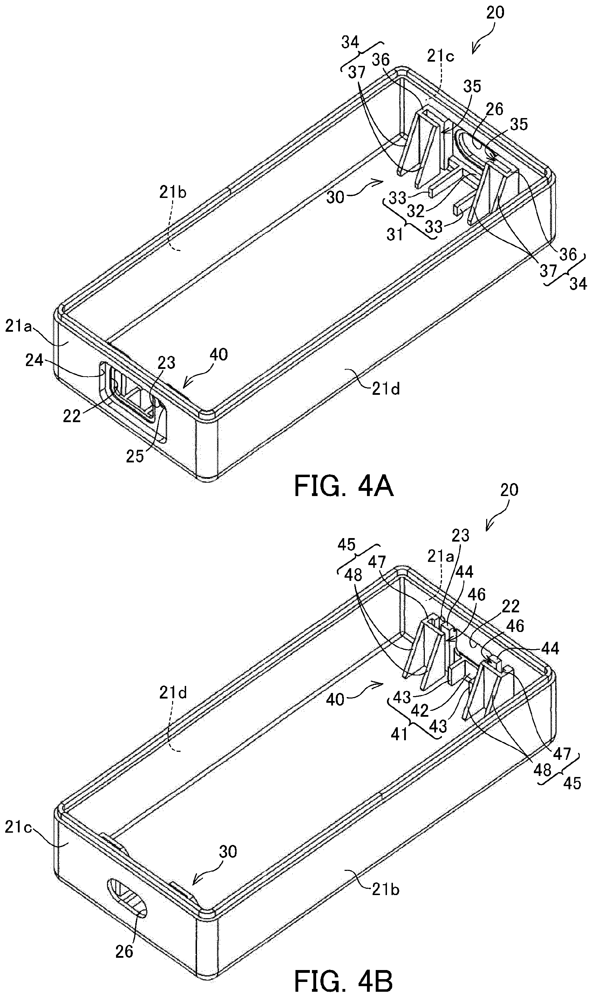

FIG. 4A is a perspective view of the upper case 20 seen from an opening 22 for bushing member side, and FIG. 4B is a perspective view of the upper case 20 seen from an opening 26 for inlet side.

As illustrated in FIG. 4A, in the first side surface 21a of the upper case 20, the opening 22 for bushing member (opening) is formed, and on the inner periphery of the opening 22 for bushing member, the first packing P1 (waterproofing member, see FIG. 3) is disposed. The first packing P1 is a waterproof sealing material.

Further, as illustrated in FIG. 4B, in the third side surface 21c of the upper case 20, the opening 26 for inlet (opening) is formed, and on the inner periphery of the opening 26 for inlet, the second packing P2 (waterproofing member, see FIG. 3) is disposed. The second packing P2 is a waterproof sealing material.

As illustrated in FIG. 4A, on the inner side of the third side surface 21c of the upper case 20, an inlet fixing portion 30 is disposed.

The inlet fixing portion 30 includes an inlet placement portion 31 where to place the inlet 80 (see FIG. 3) and two inlet side surface fixing portions 34 in a pillar shape disposed on both sides of the inlet placement portion 31.

The inlet placement portion 31 includes: a first projection 32 disposed between the two inlet side surface fixing portions 34; and two second projections 33 extending in parallel from the first projection 32 in a direction toward the inner side of the upper case 20.

The two inlet side surface fixing portions 34 each include: a first pillar-shaped member 36 with a U-shaped cross section (with a squared C-shaped cross section) having a case groove 35 for inlet (case groove) extending in the up-down direction; and second pillar-shaped members 37 in a triangular shape supporting the first pillar-shaped member 36.

The number of the case grooves 35 for inlet formed in the single upper case 20 is two.

As illustrated in FIG. 4B, on the inner side of the first side surface 21a of the upper case 20, a bushing member fixing portion 40 is disposed.

The bushing member fixing portion 40 includes a bushing member placement portion 41 where to place the bushing member 50 (see FIG. 3), two first bushing member side surface fixing portions 44 in a pillar shape disposed on both sides of the bushing member placement portion 41, and two second bushing member side surface fixing portions 45 in a pillar shape disposed on both sides of the first bushing member side surface fixing portions 44.

The bushing member placement portion 41 includes: a third projection 42 disposed between the two first bushing member side surface fixing portions 44; and two fourth projections 43 extending in parallel from the third projection 42 in a direction toward the inner side of the upper case 20.

The two first bushing member side surface fixing portions 44 are members disposed on both ends of the third projection 42 and extending in the up-down direction of the upper case 20.

The two second bushing member side surface fixing portions 45 each include: a third pillar-shaped member 47 with a J-shaped cross section having a case groove 46 for bushing member (case groove) extending in the up-down direction of the upper case 20; and fourth pillar-shaped members 48 in a triangular shape supporting the third pillar-shaped member 47.

The number of the case grooves 46 for bushing member formed in the single upper case 20 is two.

As illustrated in FIG. 4A, in the first side surface 21a of the upper case 20, the opening 22 for bushing member is formed, and in the vicinity of the opening 22 for bushing member, an upper case hole 23 (first hole) is formed. The upper case hole 23 is a hole where to dispose the internal pressure adjusting filter 60 (see FIG. 3). The diameter of the upper case hole 23 is approximately several millimeters (for example, 1.0 mm). The upper case hole 23 is a ventilation hole for internal pressure adjustment.

The opening 26 for inlet is formed at a position between the two first pillar-shaped members 36.

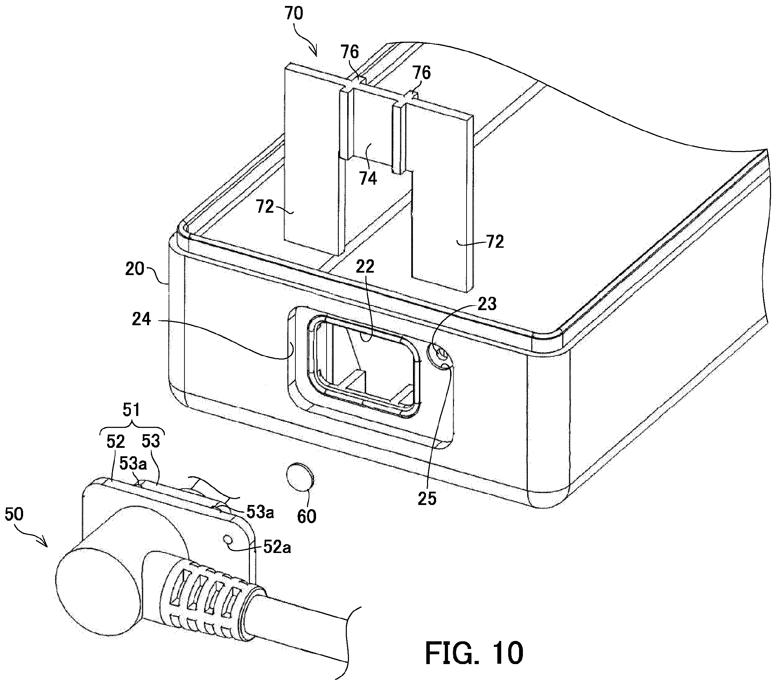

In the first side surface 21a of the upper case 20, a recess 24 dented in a direction toward the inner side of the upper case 20 is formed. The opening 22 for bushing member and the upper case hole 23 are formed in the recess 24. Note that around the upper case hole 23, an internal pressure adjusting filter housing portion 25 (see FIG. 10) further dented from the recess 24 is formed. The internal pressure adjusting filter housing portion 25 has a circular outer shape along the outer shape of the internal pressure adjusting filter 60. The internal pressure adjusting filter 60 is housed in the internal pressure adjusting filter housing portion 25.

As illustrated in FIG. 4B, the upper case hole 23 is formed at a position between one (left one in FIG. 4B) of the first bushing member side surface fixing portions 44 and the third pillar-shaped member 47.

The opening 22 for bushing member is formed at a position between the two first bushing member side surface fixing portions 44.

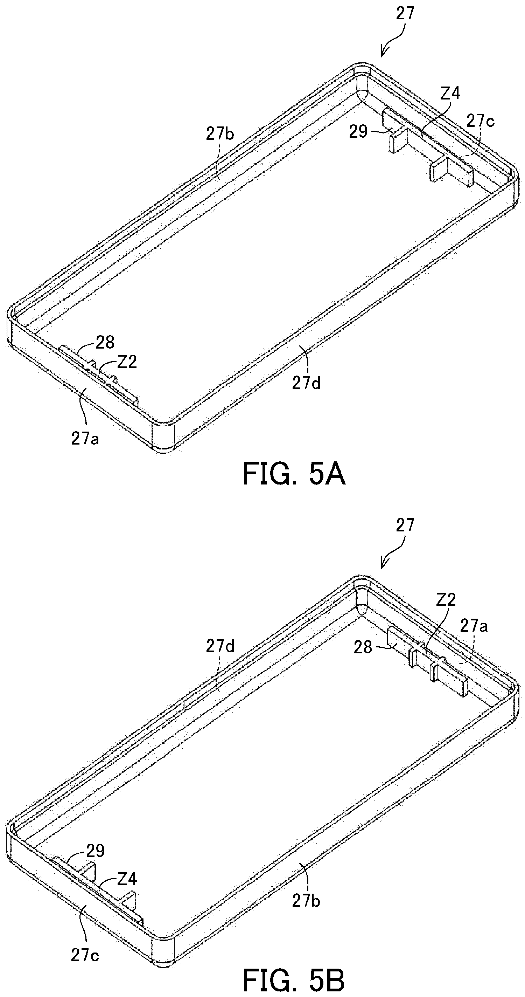

FIG. 5A is a perspective view of the lower case 27 seen from the opening 22 for bushing member side (see FIG. 4A), and FIG. 5B is a perspective view of the lower case 27 seen from the opening 26 for inlet side (see FIG. 4B).

As illustrated in FIG. 5A, on the inner side of the first side surface 27a of the lower case 27, a first fixing pin extension member 28 (contact portion, rib) is disposed. The first fixing pin extension member 28 has the same shape as the shape of the lower side of the first fixing pin 70 (see FIG. 3). Further, the first fixing pin extension member 28 is disposed at a position where it faces (position where, in the up-down direction, it overlaps) the first fixing pin 70.

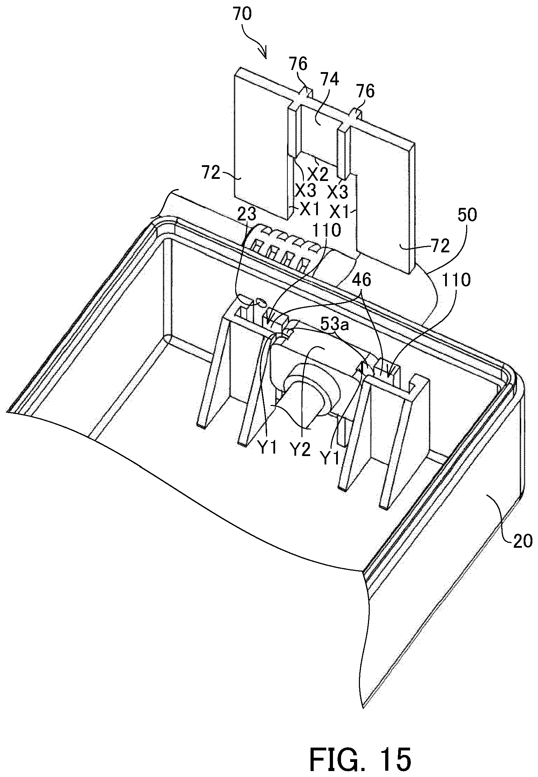

Accordingly, when the upper case 20 (see FIG. 4A and FIG. 4B) and the lower case 27 are combined, the first fixing pin extension member 28 comes into contact with the first fixing pin 70 inserted in first connected spaces 110 (see FIG. 15). That is, the first fixing pin extension member 28 pushes the first fixing pin 70 to fix it when the two cases are combined.

As illustrated in FIG. 5B, on the inner side of the third side surface 27c of the lower case 27, a second fixing pin extension member 29 (contact portion, rib) is disposed. The second fixing pin extension member 29 has the same shape as the shape of the lower side of the second fixing pin 90 (see FIG. 3). Further, the second fixing pin extension member 29 is disposed at a position where it faces (position where, in the up-down direction, it overlaps) the second fixing pin 90.

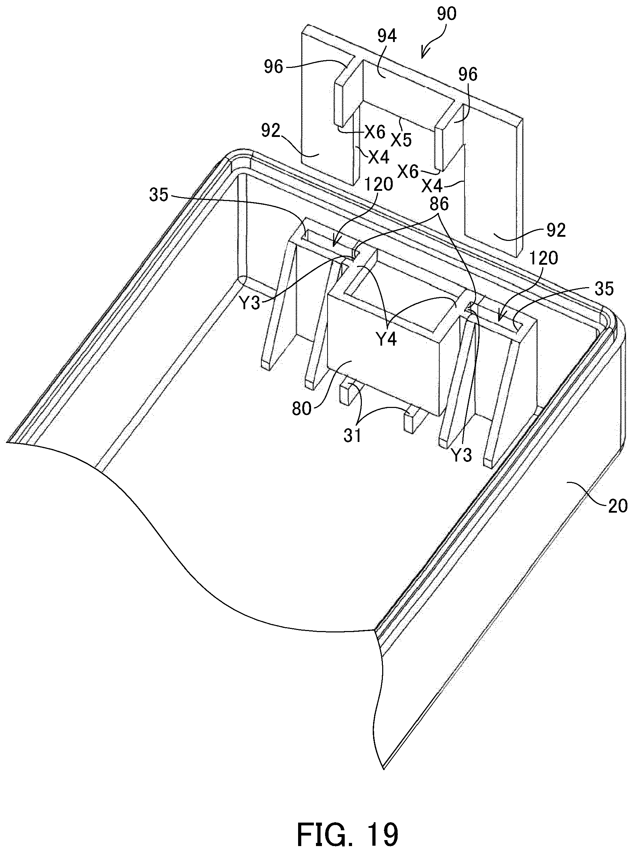

Accordingly, when the upper case 20 (see FIG. 4A and FIG. 4B) and the lower case 27 are combined, the second fixing pin extension member 29 comes into contact with the second fixing pin 90 inserted in second connected spaces 120 (see FIG. 19). That is, the second fixing pin extension member 29 pushes the second fixing pin 90 to fix it when the two cases are combined.

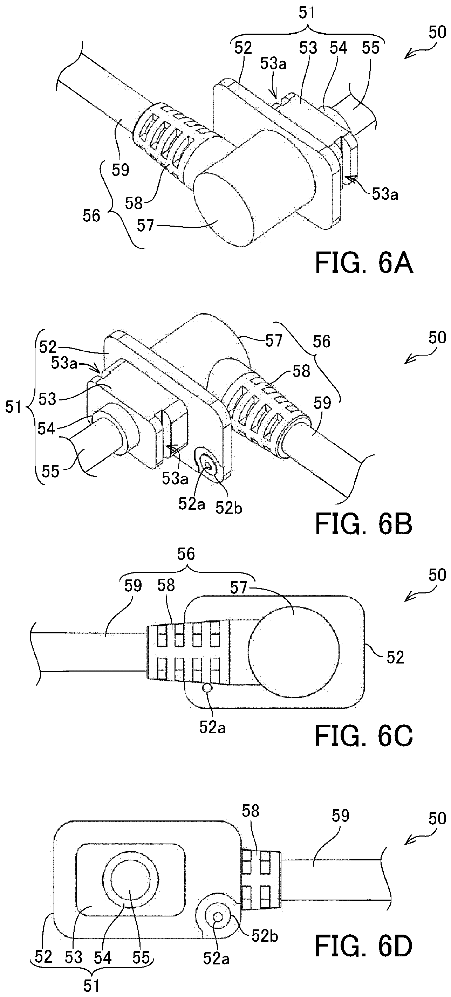

FIG. 6A is a perspective view of the bushing member 50 seen from a front surface side, FIG. 6B is a perspective view of the bushing member 50 seen from a rear surface side, FIG. 6C is a front view of the bushing member 50, and FIG. 6D is a rear view of the bushing member 50.

The bushing member 50 is an output-side member (member which is a power outlet) of the charger 100 and is partly fitted in the opening 22 for bushing member (see FIG. 3).

Further, the bushing member 50 includes a main body portion 51 and a wiring portion 56. Note that a main body portion cord 55 and a wiring portion cord 59 are actually longer members but their parts after their middles are not illustrated.

The main body portion 51 is disposed at a position where it overlaps the opening 22 for bushing member, the upper case hole 23, and the internal pressure adjusting filter 60 (see FIG. 3).

Further, the main body portion 51 includes a plate-shaped member 52, a rectangular parallelepiped member 53, bushing member grooves 53a, a main body portion column member 54, and the main body portion cord 55.

The plate-shaped member 52 is a member substantially in a rectangular plate shape. In more detail, a rectangular parallelepiped member 53-side surface of the plate-shaped member 52 is a flat surface, and a wiring portion column member 57-side surface (surface opposite to the rectangular parallelepiped member 53 side) of the plate-shaped member 52 is also a flat surface.

The rectangular parallelepiped member 53 is a member disposed on the rear surface side (in FIG. 6A, a right obliquely upward direction side) of the plate-shaped member 52.

Further, on side surfaces of the rectangular parallelepiped member 53, the bushing member grooves 53a (component grooves) are formed to extend in the up-down direction.

The number of the bushing member grooves 53a formed in the single bushing member 50 is two.

The main body portion column member 54 is a member disposed on the rear surface side (in FIG. 6A, a right obliquely upward direction side) of the rectangular parallelepiped member 53.

The main body portion cord 55 is a member disposed on the rear surface side (in FIG. 6A, a right obliquely upward direction side) of the main body portion column member 54 and formed integrally with the main body portion column member 54. Note that the main body portion cord 55 need not be a member integrally formed with the main body portion column member 54 and may be a member separate from the main body portion column member 54 and inserted in the main body portion column member 54.

The wiring portion 56 is a member extending from the main body portion 51 in a direction toward the outside of the upper case 20 (see FIG. 3).

Further, the wiring portion 56 includes a wiring portion column member 57, a wiring portion protection member 58, and the wiring portion cord 59.

The wiring portion column member 57 is a member disposed on the front surface side (in FIG. 6A, a left obliquely downward direction) of the plate-shaped member 52.

The wiring portion protection member 58 is a member disposed on the circumferential surface of the wiring portion column member 57 to protect the wiring portion cord 59.

The wiring portion cord 59 is a member formed integrally with the wiring portion protection member 58. One end of the wiring portion cord 59 is connected to the wiring portion protection member 58 and the other end of the wiring portion cord 59 is connected to the battery 210 (see FIG. 1).

Further, as illustrated in FIG. 6C, in a left lower region of the plate-shaped member 52, a bushing member hole 52a (second hole) is formed. The bushing member hole 52a is a hole formed in the plate-shaped member 52 of the bushing member 50 (electronic component) and formed at a position where it overlaps the internal pressure adjusting filter 60 (see FIG. 3). The diameter of the bushing member hole 52a is approximately several millimeters (for example, 1.5 mm).

The bushing member hole 52a is formed at a position where it does not overlap the wiring portion 56 (the wiring portion column member 57, the wiring portion protection member 58, and the wiring portion cord 59) in a front view. The bushing member hole 52a is an opening for ventilation which enables the air exit and entrance through the internal pressure adjusting filter 60 from/to the upper case hole 23 serving as the ventilation hole.

As illustrated in FIG 6B and FIG. 6D, in a right lower region of the rear surface of the plate-shaped member 52, the bushing member hole 52a is formed, and therearound, a circular projection 52b disposed to surround the bushing member hole 52a is formed. The circular projection 52b plays a role of pushing the internal pressure adjusting filter 60 housed in the internal pressure adjusting filter housing portion 25 (see FIG. 3).

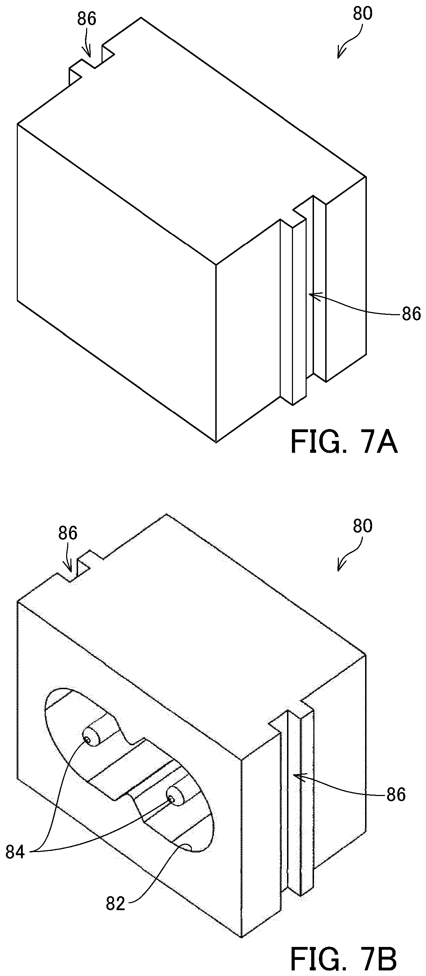

FIG. 7A is a perspective view of the inlet 80 seen from a rear surface side, and FIG. 7B is a perspective view of the inlet 80 seen from a front surface side.

The inlet 80 is an input-side member (member serving as an inlet) of the charger 100, and the power cord 300 (see FIG. 1) is inserted into the inlet 80.

The inlet 80 is disposed inside the charger 100 so as to cover the opening 26 for inlet (see FIG. 2B).

The inlet 80 includes a power cord insertion port 82, pins 84, and inlet grooves 86 (component grooves).

The power cord insertion port 82 is a portion where to insert the power cord 300 (see FIG. 1) and has a shape along the shape of one tip of the power cord 300. Specifically, the power cord insertion port 82 has a substantially elliptical shape (in more detail, a shape in which two semicircular shapes sandwich one rectangular shape and two long sides of the rectangular shape each have a projection projecting toward the center of the insertion port).

The pins 84 are components disposed inside the power cord insertion port 82 and electrically connected to the power cord 300. The pins 84 are connected to the electronic components inside.

The inlet grooves 86 are grooves formed in side surfaces of the inlet 80 and extending in the up-down direction. The number of the inlet grooves 86 formed in the single inlet 80 is two.

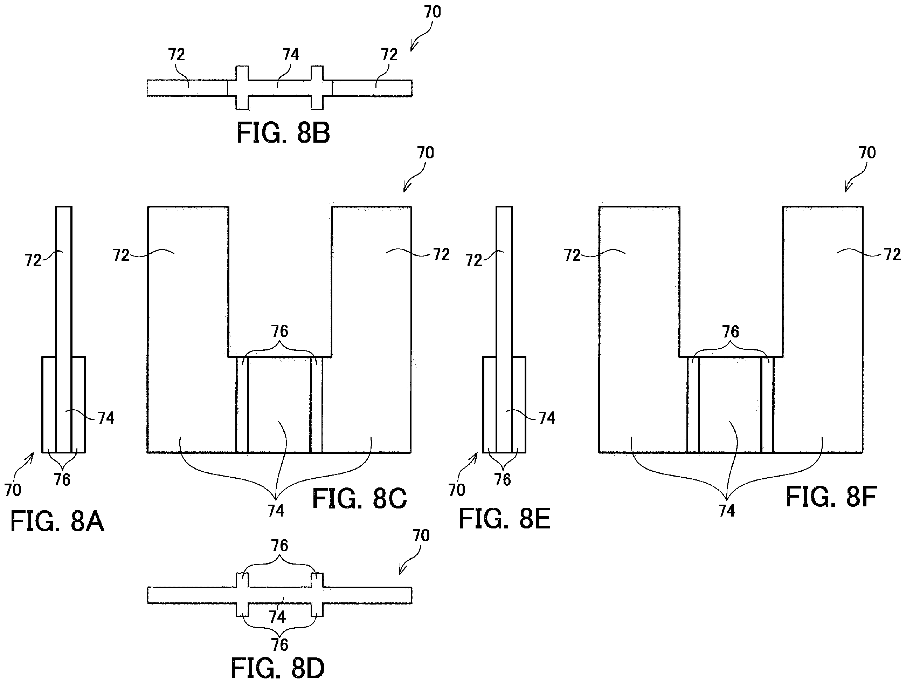

FIG. 8A is a left side view of the first fixing pin 70, FIG. 8B is a plan view of the first fixing pin 70, FIG. 8C is a front view of the first fixing pin 70, FIG. 8D is a bottom view of the first fixing pin 70, FIG. 8E is a right side view of the first fixing pin 70, and FIG. 8F is a rear view of the first fixing pin 70.

The first fixing pin 70 (fixing member) is U-shaped in a front view and is formed of resin or metal.

The first fixing pin 70 includes first fixing pin insertion portions 72, a first fixing pin connecting portion 74, and first fixing pin projections 76.

The first fixing pin insertion portions 72 are two plate-shaped members which extend in a first direction (the up-down direction in FIG. 8A, FIG. 8C, FIG. 8E, and FIG. 8F, and the Z direction in FIG. 3) being an insertion direction of the first fixing pin 70 (fixing member) and are inserted in the plurality of first connected spaces 110 (see FIG. 15).

The first fixing pin connecting portion 74 is one plate-shaped member extending in a second direction (the left-right direction in FIG. 8B, FIG. 8C, FIG. 8D, and FIG. 8F and the Y direction in FIG. 3) orthogonal to the first direction and connecting the two first fixing pin insertion portions 72.

The first fixing pin projections 76 are members provided on the first fixing pin connecting portion 74 and extending in a third direction (the front-rear direction in FIG. 8A to FIG. 8F and the X direction in FIG. 3) orthogonal to the first direction and the second direction.

The first fixing pin insertion portions 72 of the first fixing pin 70 preferably have a size large enough to be inserted in the first connected spaces 110 (see FIG. 15) without leaving any gap. However, setting the size of the first fixing pin insertion portions 72 of the first fixing pin 70 smaller than the size of the first connected spaces 110 facilitates inserting the first fixing pin insertion portions 72 into the first connected spaces 110, and setting the size of the first fixing pin insertion portions 72 of the first fixing pin 70 larger than the size of the first connected spaces 110 (size with which the first fixing pin insertion portions 72 can be inserted by being strongly pushed) enables to prevent the first fixing pin insertion portions 72 from coming off the first connected spaces 110.

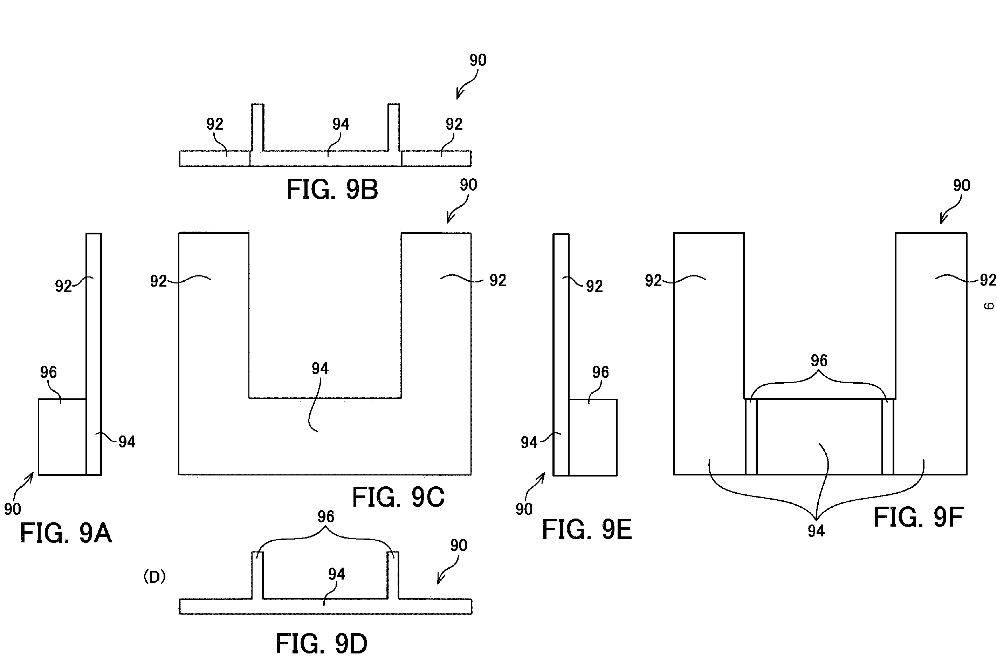

FIG. 9A is a left side view of the second fixing pin 90, FIG. 9B is a plan view of the second fixing pin 90, FIG. 9C is a front view of the second fixing pin 90, FIG. 9D is a bottom view of the second fixing pin 90, FIG. 9E is a right side view of the second fixing pin 90, and FIG. 9F is a rear view of the second fixing pin 90.

The second fixing pin 90 (fixing member) is U-shaped in a front view and is formed of resin or metal.

The second fixing pin 90 includes second fixing pin insertion portions 92, a second fixing pin connecting portion 94, and second fixing pin projections 96.

The second fixing pin insertion portions 92 are two plate-shaped members which extend in the first direction (the up-down direction in FIG. 9A, FIG. 9C, FIG. 9E, and FIG. 9F and the Z direction in FIG. 3) being an insertion direction of the second fixing pin 90 (fixing member) and are inserted in the plurality of second connected spaces 120 (see FIG. 19).

The second fixing pin connecting portion 94 is one plate-shaped member extending in the second direction (the left-right direction in FIG. 9B, FIG. 9C, FIG. 9D, and FIG. 9F and the Y direction in FIG. 3) orthogonal to the first direction and connecting the two second fixing pin insertion portions 92.

The second fixing pin projections 96 are members provided on the second fixing pin connecting portion 94 and extending in the third direction (the front-rear direction in FIG. 9A to FIG. 9F and the X direction in FIG. 3) orthogonal to the first direction and the second direction.

The second fixing pin insertion portions 92 of the second fixing pin 90 preferably have a size large enough to be inserted in the second connected spaces 120 (see FIG. 19) without leaving any gap. However, setting the size of the second fixing pin insertion portions 92 of the second fixing pin 90 smaller than the size of the second connected spaces 120 facilitates inserting the second fixing pin insertion portions 92 into the second connected spaces 120, and setting the size of the second fixing pin insertion portions 92 of the second fixing pin 90 larger than the size of the second connected spaces 120 (size with which the second fixing pin insertion portions 92 can be inserted by being strongly pushed) enables to prevent the second fixing pin insertion portions 92 from coming off the second connected spaces 120.

FIG. 10 to FIG. 17 are views illustrating a method of fixing the bushing member 50.

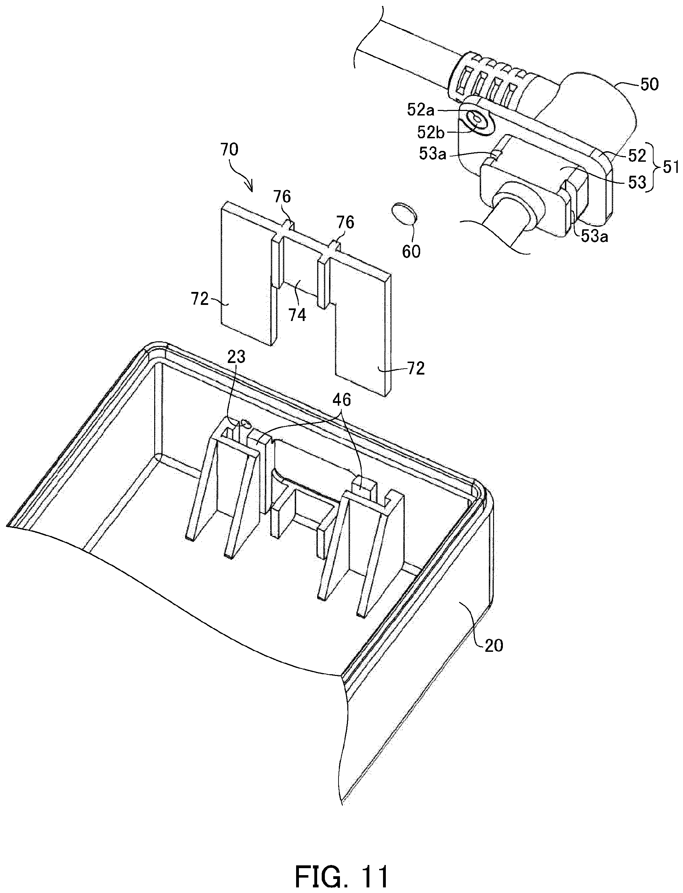

FIG. 10, FIG. 12, FIG. 14, and FIG. 16 are perspective views in which the bushing member 50 is seen from the front surface side, and FIG. 11, FIG. 13, FIG. 15, and FIG. 17 are perspective views in which the bushing member 50 is seen from the rear surface side.

The method of fixing the bushing member 50 is as follows.

First, as illustrated in FIG. 10 and FIG. 11, the upper case 20 is disposed up-side-down (disposed with the open portion of the upper case 20 facing upward), and the bushing member 50, the internal pressure adjusting filter 60, and the first fixing pin 70 are prepared.

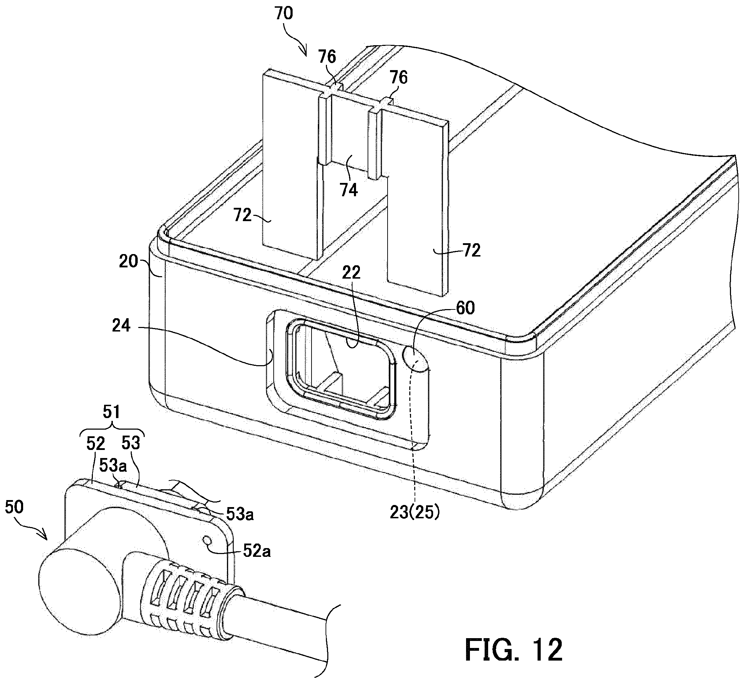

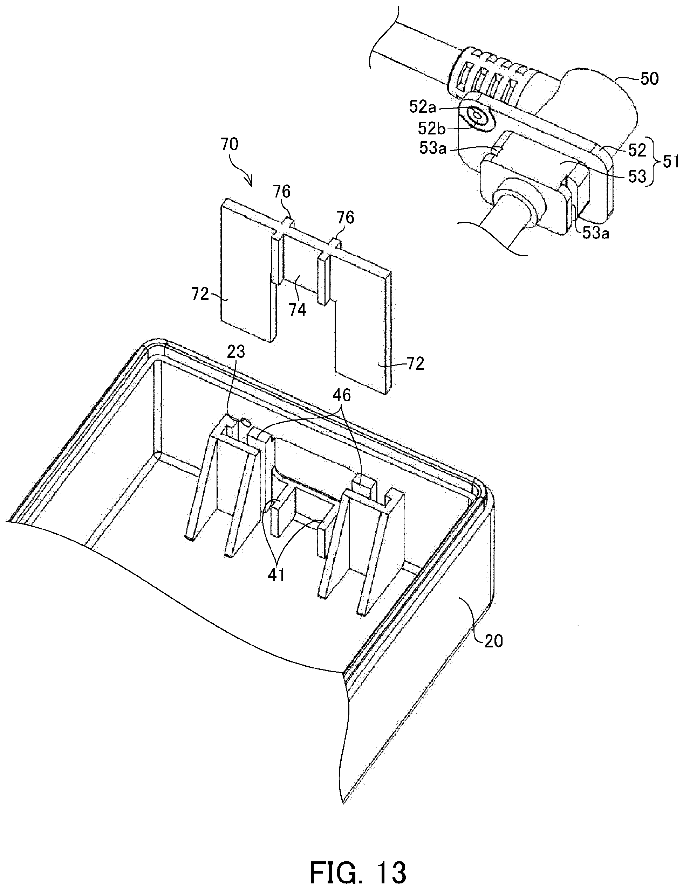

Next, as illustrated in FIG. 12 and FIG. 13, the internal pressure adjusting filter 60 is housed in the internal pressure adjusting filter housing portion 25 in the recess 24 of the upper case 20. Consequently, the internal pressure adjusting filter 60 is disposed at the position where it overlaps the upper case hole 23. In more detail, the internal pressure adjusting filter 60 is disposed in a stacked manner on the upper case hole 23 formed in the recess 24. Consequently, the internal pressure adjusting filter 60 is stuck to the upper case 20 with the ring-shaped double-sided adhesive tape, to cover the upper case hole 23.

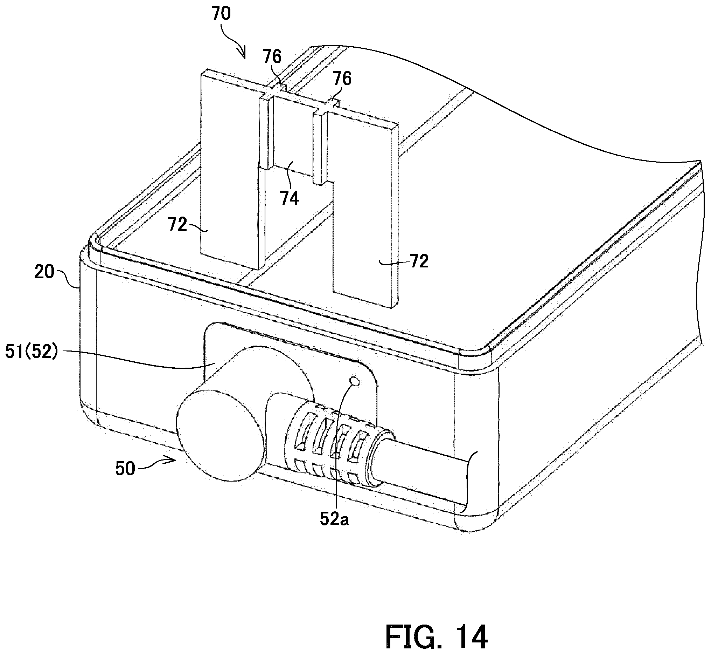

Further, as illustrated in FIG. 14 and FIG. 15, the main body portion 51 of the bushing member 50 is fitted into the recess 24 of the upper case 20. In this case, the main body portion 51 is at least partly housed in the recess 24. In more detail, the main body portion 51 is disposed at the position where it overlaps the opening 22 for bushing member formed in the recess 24 and also overlaps the upper case hole 23 and the internal pressure adjusting filter 60 which are disposed in the recess 24. Consequently, the bushing member 50 is disposed at the position where it overlaps the opening 22 for bushing member, the upper case hole 23, and the internal pressure adjusting filter 60.

Further, when the main body portion 51 of the bushing member 50 is fitted in the recess 24 of the upper case 20, the bushing member 50 is placed on the bushing member placement portion 41. At this time, the circular projection 52b works to push the internal pressure adjusting filter 60 housed in the internal pressure adjusting filter housing portion 25.

Further, when the main body portion 51 of the bushing member 50 is fitted in the recess 24 of the upper case 20, the bushing member grooves 53a of the bushing member 50 and the case grooves 46 for bushing member of the upper case 20 are connected to form the first connected spaces 110.

The two first connected spaces 110 are formed by the two case grooves 46 for bushing member and the two bushing member grooves 53a of the bushing member 50 being thus connected.

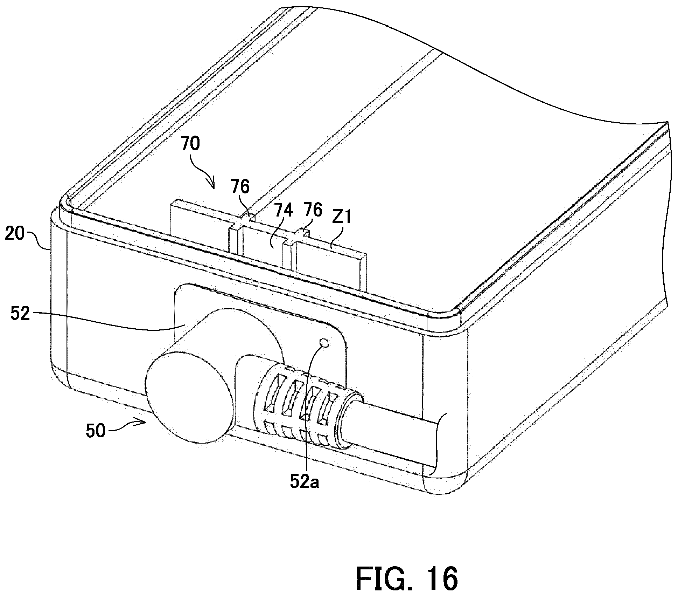

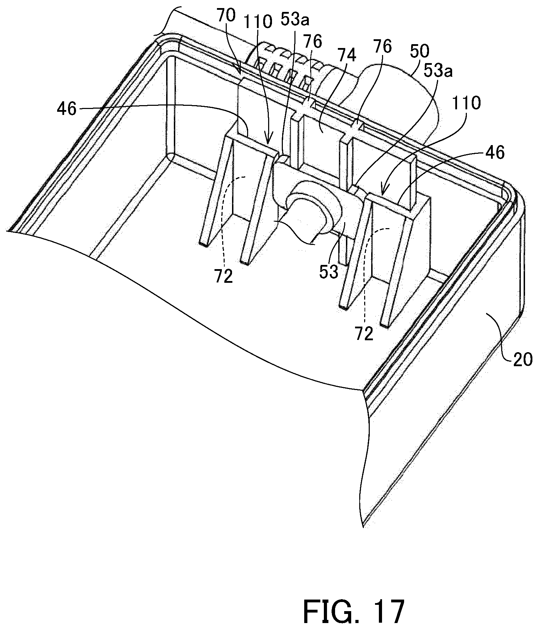

Then, as illustrated in FIG. 16 and FIG. 17, the first fixing pin insertion portions 72 of the first fixing pin 70 are inserted into the first connected spaces 110. In this case, the two first fixing pin insertion portions 72 connected by the first fixing pin connecting portion 74 are inserted into the two first connected spaces 110. Consequently, the first fixing pin insertion portions 72 are disposed all through the case grooves 46 for bushing member and the bushing member grooves 53a which form the first connected spaces 110, thereby fixing the bushing member 50 to the upper case 20.

At this time, inner end surfaces (see X1 in FIG. 15) of the two first fixing pin insertion portions 72 of the first fixing pin 70 and an inner end surface (see X2 in FIG. 15) of the first fixing pin connecting portion 74 of the first fixing pin 70 come into contact with side surfaces (see Y1 in FIG. 15) and the bottom surface (see Y2 in FIG. 15) of the bushing member 50.

Further, inner end surfaces (see X3 in FIG. 15) of the first fixing pin projections 76 of the first fixing pin 70 come into contact with the bottom surface (see Y2 in FIG. 15) of the bushing member 50.

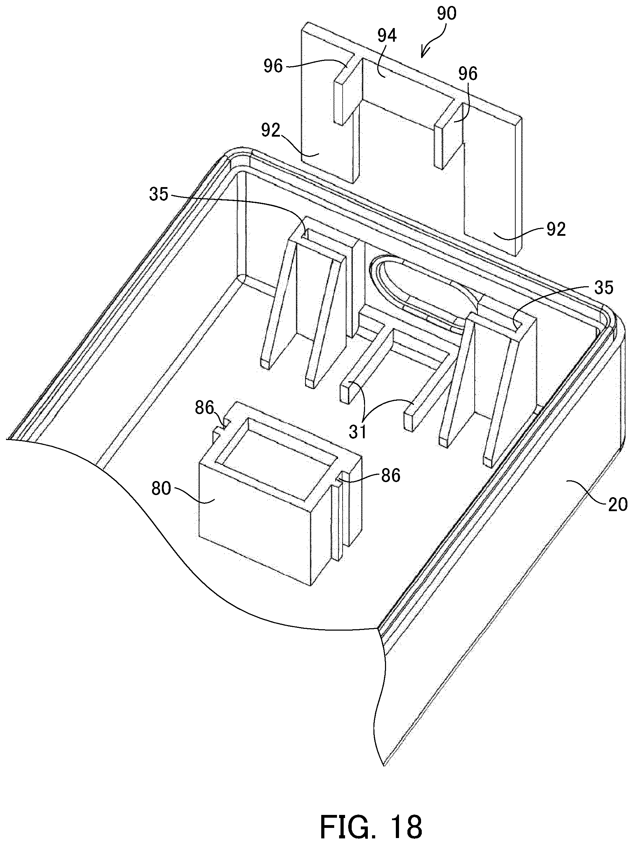

FIG. 18 to FIG. 20 are views illustrating a method of fixing the inlet 80.

FIG. 18 to FIG. 20 are perspective views in which the inlet 80 is seen from the rear surface side.

The method of fixing the inlet 80 is as follows.

First, as illustrated in FIG. 18, the upper case 20 is disposed up-side-down and the inlet 80 and the second fixing pin 90 are prepared.

Next, as illustrated in FIG. 19, the inlet 80 is placed on the inlet placement portion 31.

When the inlet 80 is placed on the inlet placement portion 31, the inlet grooves 86 of the inlet 80 and the case grooves 35 for inlet of the upper case 20 are connected to form the second connected spaces 120.

The two second connected spaces 120 are formed by the two inlet grooves 86 and the two case grooves 35 for inlet being thus connected.

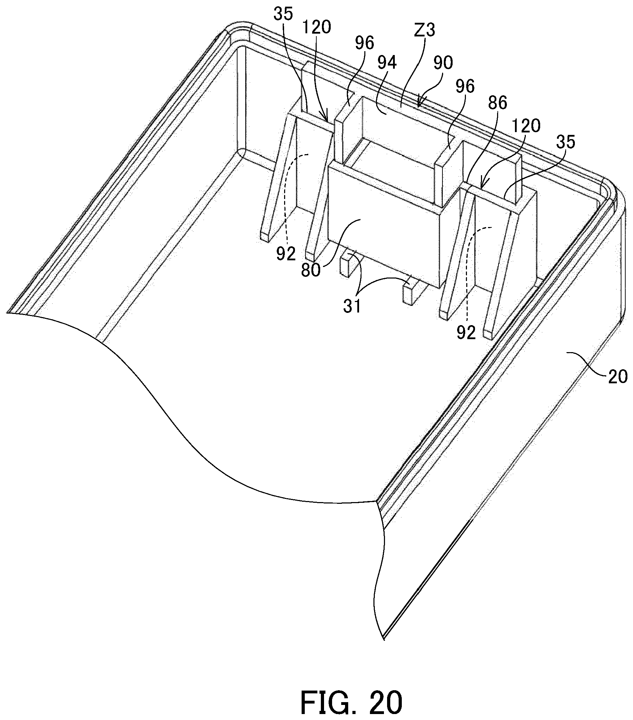

Then, as illustrated in FIG. 20, the second fixing pin insertion portions 92 of the second fixing pin 90 are inserted into the second connected spaces 120. In this case, the two second fixing pin insertion portions 92 connected by the second fixing pin connecting portion 94 are inserted into the two second connected spaces 120. Consequently, the second fixing pin insertion portions 92 are disposed all through the case grooves 35 for inlet and the inlet grooves 86 which form the second connected spaces 120, thereby fixing the inlet 80 to the upper case 20.

At this time, inner end surfaces (see X4 in FIG. 19) of the two second fixing pin insertion portions 92 of the second fixing pin 90 and an inner end surface (see X5 in FIG. 19) of the second fixing pin connecting portion 94 of the second fixing pin 90 come into contact with side surfaces (see Y3 in FIG. 19) and the bottom surface (see Y4 in FIG. 19) of the inlet 80.

Further, inner end surfaces (see X6 in FIG. 19) of the second fixing pin projections 96 of the second fixing pin 90 come into contact with the bottom surface (see Y4 in FIG. 19) of the inlet 80.

Then, finally, the lower case 27 is stacked on the upper case 20. Consequently, the bottom surface (see Z1 in FIG. 16) of the first fixing pin connecting portion 74 comes into contact with the upper surface (see Z2 in FIG. 5A and FIG. 5B) of the first fixing pin extension member 28 of the lower case 27. Further, the bottom surface (see Z3 in FIG. 20) of the second fixing pin connecting portion 94 comes into contact with the upper surface (see Z4 in FIG. 5A and FIG. 5B) of the second fixing pin extension member 29 of the lower case 27. Consequently, the first fixing pin 70 and the second fixing pin 90 are fixed.

Note that the upper case 20 and the lower case 27 are fixed with not-illustrated fixing means (screws, pins, bonding means, or the like).

Consequently, the charger 100 illustrated in FIG. 2A and FIG. 2B is completed.

As described above, this embodiment has the following effects.
(1) According to this embodiment, since the first fixing pin 70 is inserted in the first connected spaces 110 to fix the bushing member 50 to the upper case 20 and the second fixing pin 90 is inserted in the second connected spaces 120 to fix the inlet 80 to the upper case 20, the space-saving fixation of the bushing member 50 and the inlet 80 is enabled without using screws or the like.
(2) According to this embodiment, since the first fixing pin 70 is disposed all through the case grooves 46 for bushing member and the bushing member grooves 53a which form the first connected spaces 110 and the second fixing pin 90 is disposed all through the case grooves 35 for inlet and the inlet grooves 86 which form the second connected spaces 120, it is possible not only to firmly fix the bushing member 50 and the inlet 80 to the upper case 20 but also to firmly fix the first packing P1 and the second packing P2 which are disposed on the inner peripheries of the opening 22 for bushing member and the opening 26 for inlet, to improve waterproofness (waterproof sealability), and as a result, a novel waterproof structure is achieved.
(3) According to this embodiment, since the first fixing pin 70 made of resin and the second fixing pin 90 made of resin fix the bushing member 50 and the inlet 80, an electrical influence on the electronic components and the electronic circuit device which are provided inside can be smaller than in a fixing method using metal screws.
(4) According to this embodiment, since the plurality of connected spaces such as the first connected spaces 110 and the second connected spaces 120 are formed and the first fixing pin insertion portions 72 and the second fixing pin insertion portions 92 are inserted in the first connected spaces 110 and the second connected spaces 120 which are the plurality of connected spaces, it is possible to more strengthen the fixation by the first fixing pin 70 and the second fixing pin 90 than in a situation in which there are only one connected space and only one insertion portion.
(5) According to this embodiment, since, in the first fixing pin 70, the two first fixing pin insertion portions 72 are united by the first fixing pin connecting portion 74 and in the second fixing pin 90, the two second fixing pin insertion portions 92 are united by the second fixing pin connecting portion 94, it is possible to insert the two first fixing pin insertion portions 72 into the two first connected spaces 110 at a time and insert the two second fixing pin insertion portions 92 into the two second connected spaces 120 at a time, enabling improved work efficiency.
(6) According to this embodiment, since it is possible to bring two parts, that is, the first fixing pin insertion portions 72 and the first fixing pin connecting portion 74 of the first fixing pin 70 into contact with the bushing member 50 and to bring two parts, that is, the second fixing pin insertion portions 92 and the second fixing pin connecting portion 94 of the second fixing pin 90 into contact with the inlet 80, the bushing member 50 and the inlet 80 can be stably fixed to the upper case 20.
(7) According to this embodiment, since it is possible to bring three parts, that is, the first fixing pin insertion portions 72, the first fixing pin connecting portion 74, and the first fixing pin projections 76 of the first fixing pin 70 into contact with the bushing member 50 and to bring three parts, that is, the second fixing pin insertion portions 92, the second fixing pin connecting portion 94, and the second fixing pin projections 96 of the second fixing pin 90 into contact with the inlet 80, the bushing member 50 and the inlet 80 can be more stably fixed to the upper case 20.
(8) According to this embodiment, since the first fixing pin extension member 28 and the second fixing pin extension member 29 are provided which come into contact with the first fixing pin 70 inserted in the first connected spaces 110 and the second fixing pin 90 inserted in the second connected spaces 120 when the upper case 20 and the lower case 27 are combined, it is possible to easily and firmly fix the first fixing pin 70 and the second fixing pin 90 by the first fixing pin extension member 28 and the second fixing pin extension member 29 while the two cases are combined.
(9) According to this embodiment, since the internal pressure adjusting filter 60 is disposed at the back of the bushing member hole 52a of the bushing member 50, the internal pressure adjusting filter 60 is hidden behind the bushing member 50 and thus can be less conspicuous than in a type in which the internal pressure adjusting filter 60 is disposed on an outer wall of the upper case 20, and as a result, it is possible to prevent the internal pressure adjusting filter 60 from impairing the design attractiveness of the charger 100.
(10) According to this embodiment, since the bushing member hole 52a is disposed in the bushing member 50, there is no need to form a conspicuous hole in the outer wall of the upper case 20, and it is possible to dispose the internal pressure adjusting filter 60 without impairing the external appearance of the upper case 20.
(11) According to this embodiment, since the bushing member 50 can press the internal pressure adjusting filter 60, a specialized component for pressing the internal pressure adjusting filter 60 is not necessary, enabling a reduction in the number of components.
(12) According to this embodiment, since the bushing member 50 can press the internal pressure adjusting filter 60, it is possible to avoid a situation in which the internal pressure adjusting filter 60 comes off accidentally.
(13) According to this embodiment, the bushing member hole 52a is formed in the main body portion 51 at the position where it does not overlap the wiring portion 56, and accordingly, when a test of sticking a tape on the bushing member hole 52a is conducted before the shipment of the charger 100, it is possible to reduce the occurrence of a situation in which the wiring portion 56 becomes an obstacle to make it difficult to stick the tape, enabling improved work efficiency.
(14) According to this embodiment, since the main body portion 51 is at least partly housed in the recess 24, it is possible to bury at least part of the main body portion 51, which is part of the bushing member 50, inside the upper case 20, making it possible to reduce deterioration in design attractiveness which would occur if the main body portion 51 protrudes too much to the outside of the upper case 20.
(15) According to this embodiment, since the opening 22 for bushing member, the upper case hole 23, and the internal pressure adjusting filter 60 are all disposed together in the recess 24, it is possible to dispose these elements compactly, enabling space-saving.
(16) According to this embodiment, since the main body portion 51 is disposed at the position where it overlaps the opening 22 for bushing member which is formed in the recess 24 and also overlaps the upper case hole 23 and the internal pressure adjusting filter 60 which are disposed in the recess 24, only by housing the main body portion 51 in the recess 24, it is possible to stack the main body portion 51 on the opening 22 for bushing member, the upper case hole 23, and the internal pressure adjusting filter 60, enabling improved work efficiency.

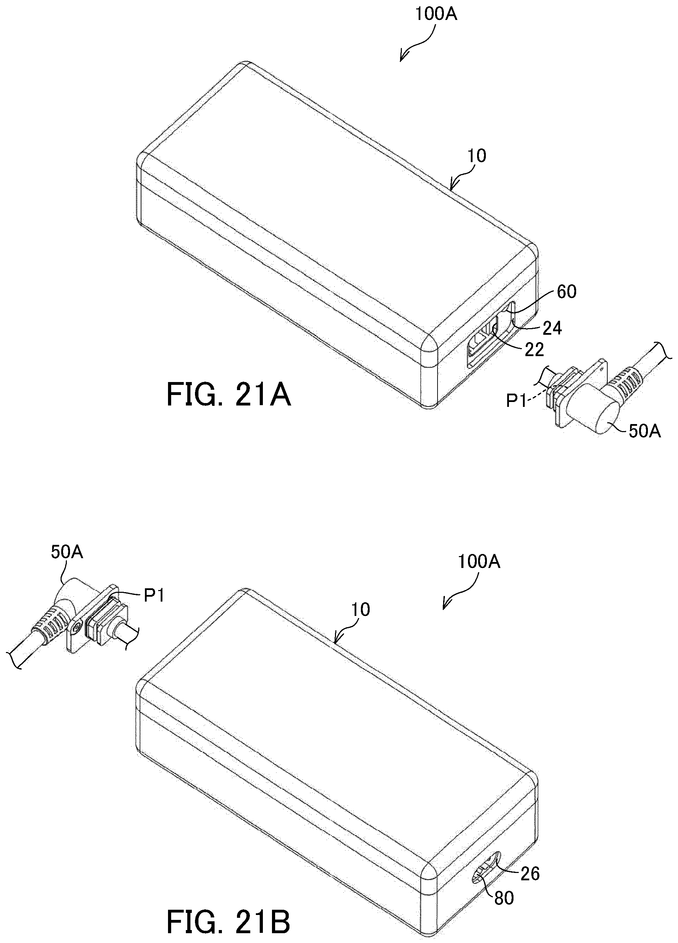

FIG. 21A and FIG. 21B are perspective views illustrating a charger 100A of another embodiment.

Note that, in the following description and drawings, parts having the same functions as those in the previously described embodiment will be denoted by the same reference signs, and a redundant description thereof will be omitted when appropriate.

FIG. 21A is a perspective view of the charger 100A seen from a bushing member 50A side, and FIG. 21B is a perspective view of the charger 100A seen from an inlet 80 side.

The charger 100A includes a box-shaped case 10.

As illustrated in FIG. 21A, in one side surface (one of the side surfaces arranged in the longitudinal direction of the case 10) of the case 10, an opening 22 for bushing member to which the bushing member 50A is attachable is formed.

Further, as illustrated in FIG. 21B, in another side surface of the case 10, an opening 26 for inlet into which the power cord 300 (see FIG. 1) is insertable is formed. Inside the opening 26 for inlet, the inlet 80 is disposed.

In the previously described embodiment, the first packing P1 is disposed near the inner periphery of the opening 22 for bushing member, but in this embodiment, a first packing P1 is attached to the bushing member 50A.

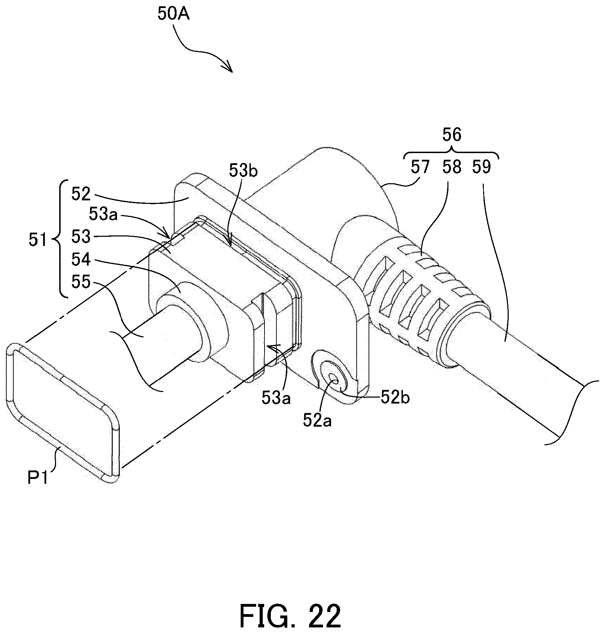

FIG. 22 is a view illustrating the bushing member 50A of the other embodiment. This drawing is a perspective view of the bushing member 50A seen from a rear surface side.

In a rectangular parallelepiped member 53 of the bushing member 50A, a groove 53b for packing is formed near a plate-shaped member 52-side end portion. The groove 53b for packing is formed to surround the outer periphery of the rectangular parallelepiped member 53.

The first packing P1 is attached to the groove 53b for packing. Being a member having elasticity, the first packing P1 can be attached to the groove 53b for packing by being expanded in size.

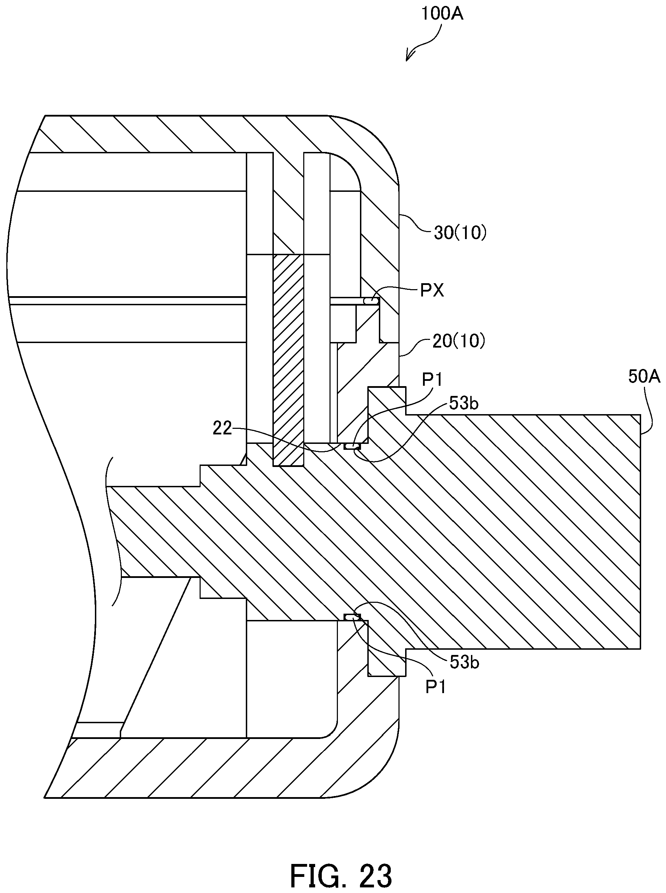

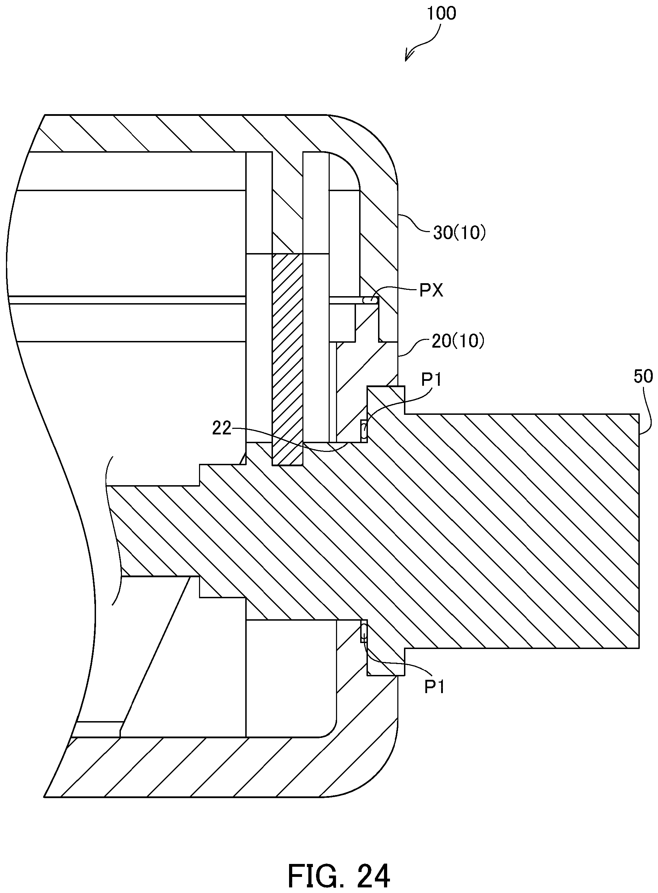

FIG. 23 is a vertical sectional view of the charger 100A of the other embodiment, and FIG. 24 is a vertical sectional view of the charger 100 of the previously described embodiment.

As illustrated in FIG. 23, in the other embodiment, the first packing P1 is attached to the groove 53b for packing of the bushing member 50A. Accordingly, when the bushing member 50A is fitted in the opening 22 for bushing member of the upper case 20, the first packing P1 is sandwiched between the upper case 20 and the bushing member 50A in the up-down direction in FIG. 23. This can improve sealability by the first packing P1 to improve waterproofness.

As illustrated in FIG. 24, in the previously-described embodiment, the first packing P1 is attached near the inner periphery of the opening 22 for bushing member. Accordingly, when the bushing member 50 is fitted in the opening 22 for bushing member of the upper case 20, the first packing P1 is sandwiched between the upper case 20 and the bushing member 50 in the left-right direction in FIG. 24. This can improve waterproofness by the first packing P1 without complicating the shape of the bushing member 50.

The present invention is described, taking its application to the charger as an example, but is also applicable to electronic device units (for example, a portable information terminal, a mobile phone, a laptop personal computer, a video camera, and the like) other than a charger.

The first fixing pin insertion portions 72 of the first fixing pin 70 and the second fixing pin insertion portions 92 of the second fixing pin 90 are described as having the rectangular parallelepiped shape as an example, but their shape may be a shape at least partly having a wedge shape whose width is large at its rear end side and becoming gradually narrower toward its leading end side (shape whose insertion-direction leading end is pointed).

## Claims

1. An electronic device unit (100) comprising: a box-shaped case (10); a recess (24) formed in a first side surface of the case (10) and dented toward an inner side of the case (10); an opening (22) formed in the recess (24); a first hole (23) formed in the recess (24) and formed in the vicinity of the opening (22); an internal pressure adjusting filter (60) which is disposed at a position where the internal pressure adjusting filter (60) overlaps the first hole (23), to adjust an internal pressure of the case (10) ; a bushing member (50) attached to the case (10); and a cord (59) connected to the case (10),
wherein the internal pressure adjusting filter (60) is disposed from an outer side of the case (10) in a stacked manner on the first hole (23),
wherein in the case (10), the bushing member (50) is disposed in the recess (24) in a stacked manner on the opening (22), the first hole (23), and the internal pressure adjusting filter (60),
wherein the bushing member (50) includes a main body portion (51) and a wiring portion (56), wherein
in the main body portion (51), a second hole (52a) is formed at a position where the second hole (52a) overlaps the first hole (23) and the internal pressure adjusting filter (60) so that the internal pressure adjusting filter (60) disposed on the outer side of the first hole (23) is disposed at the back of the second hole (52a),
the main body portion (51), disposed in a stacked manner on the opening (22) , the first hole (23), and the internal pressure adjusting filter (60) and at least partly housed in the recess (24), hides the internal pressure adjusting filter (60) behind the main body portion (51) itself and presses the internal pressure adjusting filter (60), and
the wiring portion (56), which has a function of protecting the cord (59), is formed to extend from the main body portion (51) in a direction toward an outer side of the case (10), and the second hole (52a) is formed at a position where the second hole (52a) does not overlap the wiring portion (56).

2. The electronic device unit (100) according to claim 1,
**characterized in that** the main body portion (51) is disposed at a position where the main body portion (51) overlaps the opening (22) which is formed in the recess (24), and the first hole (23) and the internal pressure adjusting filter (60) which are disposed in the recess (24).

## Patentansprüche

1. Elektronische Vorrichtungseinheit (100), umfassend: ein kastenförmiges Gehäuse (10); eine Vertiefung (24), die in einer ersten Seitenfläche des Gehäuses (10) ausgebildet ist und zu einer Innenseite des Gehäuses (10) hin eingedrückt ist; eine in der Vertiefung (24) ausgebildete Öffnung (22); ein erstes Loch (23), das in der Vertiefung (24) ausgebildet ist und das in der Nähe der Öffnung (22) ausgebildet ist; einen Innendruckeinstellungsfilter (60), der an einer Position angeordnet ist, an der der Innendruckeinstellungsfilter (60) das erste Loch (23) überlappt, um einen Innendruck des Gehäuses (10) einzustellen; ein Buchsenelement (50), das an dem Gehäuse (10) angebracht ist; und ein Kabel (59), das mit dem Gehäuse (10) verbunden ist,
wobei der Innendruckeinstellungsfilter (60) von einer Außenseite des Gehäuses (10) aus gestapelt auf dem ersten Loch (23) angeordnet ist,
wobei in dem Gehäuse (10) das Buchsenelement (50) in der Vertiefung (24) gestapelt auf der Öffnung (22), dem ersten Loch (23) und dem Innendruckeinstellungsfilter (60) angeordnet ist,
wobei das Buchsenelement (50) einen Hauptkörperabschnitt (51) und einen Verdrahtungsabschnitt (56) enthält, wobei
in dem Hauptkörperabschnitt (51) ein zweites Loch (52a) an einer Position ausgebildet ist, an der das zweite Loch (52a) das erste Loch (23) und den Innendruckeinstellungsfilter (60) überlappt, so dass der Innendruckeinstellungsfilter (60), der an der Außenseite des ersten Lochs (23) angeordnet ist, an der Rückseite des zweiten Lochs (52a) angeordnet ist,
der Hauptkörperabschnitt (51), der gestapelt auf der Öffnung (22), dem ersten Loch (23) und dem Innendruckeinstellungsfilter (60) angeordnet und zumindest teilweise in der Vertiefung (24) untergebracht ist, den Innendruckeinstellungsfilter (60) hinter dem Hauptkörperabschnitt (51) selbst verbirgt und den Innendruckeinstellungsfilter (60) drückt, und
der Verdrahtungsabschnitt (56), der eine Schutzfunktion für das Kabel (59) aufweist, so ausgebildet ist, dass er sich von dem Hauptkörperabschnitt (51) in einer Richtung zu einer Außenseite des Gehäuses (10) erstreckt, und das zweite Loch (52a) an einer Position ausgebildet ist, an der das zweite Loch (52a) den Verdrahtungsabschnitt (56) nicht überlappt.

2. Elektronische Vorrichtungseinheit (100) nach Anspruch 1,
**dadurch gekennzeichnet, dass** der Hauptkörperabschnitt (51) an einer Position angeordnet ist, an der der Hauptkörperabschnitt (51) die Öffnung (22), die in der Vertiefung (24) ausgebildet ist, und das erste Loch (23) sowie den Innendruckeinstellungsfilter (60), die in der Vertiefung (24) angeordnet sind, überlappt.

## Revendications

1. Unité de dispositif électronique (100) comprenant : un boîtier en forme de boîte (10) ; un évidement (24) formé dans une première surface latérale du boîtier (10) et enfoncé vers un côté intérieur du boîtier (10) ; une ouverture (22) formée dans l'évidement (24) ; un premier trou (23) formé dans l'évidement (24) et formé à proximité de l'ouverture (22) ; un filtre de régulation de pression interne (60) qui est disposé à un emplacement où le filtre de régulation de pression interne (60) recouvre le premier trou (23), afin de réguler une pression interne du boîtier (10) ; un élément de raccordement (50) fixé au boîtier (10) ; et un cordon (59) relié au boîtier (10),
dans lequel le filtre de régulation de pression interne (60) est disposé depuis un côté extérieur du boîtier (10) d'une manière empilée sur le premier trou (23),
dans lequel, dans le boîtier (10), l'élément de raccordement (50) est disposé dans l'évidement (24) d'une manière empilée sur l'ouverture (22), le premier trou (23) et le filtre de régulation de pression interne (60),
dans lequel l'élément de raccordement (50) comprend une partie corps principal (51) et une partie de câblage (56), où
dans la partie corps principal (51), un second trou (52a) est formé à un emplacement où le second trou (52a) recouvre le premier trou (23) et le filtre de régulation de pression interne (60), de sorte que le filtre de régulation de pression interne (60) disposé sur le côté extérieur du premier trou (23) est disposé à l'arrière du second trou (52a),
la partie corps principal (51), disposée d'une manière empilée sur l'ouverture (22), le premier trou (23) et le filtre de régulation de pression interne (60) et au moins partiellement logée dans l'évidement (24), cache le filtre de régulation de pression interne (60) derrière la partie corps principal (51) elle-même et appuie sur le filtre de régulation de pression interne (60), et
la partie de câblage (56), qui a une fonction de protection du cordon (59), est formée de manière à s'étendre depuis la partie corps principal (51) dans une direction vers un côté extérieur du boîtier (10), et le second trou (52a) est formé à un emplacement où le second trou (52a) ne recouvre pas la partie de câblage (56).

2. Unité de dispositif électronique (100) selon la revendication 1,
**caractérisée en ce que** la partie corps principal (51) est disposée à un emplacement où la partie corps principal (51) recouvre l'ouverture (22) qui est formée dans l'évidement (24), et le premier trou (23) et le filtre de régulation de pression interne (60) qui sont disposés dans l'évidement (24).
